Europäisches Patentamt

European Patent Office

Office européen des brevets

(19)

(11) Publication number: **0 214 830 B1**

# EUROPEAN PATENT SPECIFICATION

(45) Date of publication of patent specification: **28.08.91**  (51) Int. Cl.⁵: **H01R 9/07**

(21) Application number: **86306772.4**

(22) Date of filing: **02.09.86**

(54) FPC connector.

(30) Priority: **06.09.85 JP 197134/85**

(43) Date of publication of application:
**18.03.87 Bulletin 87/12**

(45) Publication of the grant of the patent:
**28.08.91 Bulletin 91/35**

(84) Designated Contracting States:
**AT BE CH DE FR GB IT LI LU NL SE**

(56) References cited:
**EP-A- 0 072 492**
**DE-B- 1 112 774**
**US-A- 3 159 447**
**US-A- 3 696 319**

(73) Proprietor: **E.I. DU PONT DE NEMOURS AND COMPANY**
**1007 Market Street**
**Wilmington Delaware 19898(US)**

(72) Inventor: **Kinoshita, Toshio**
**412 Hinodai-Heights 1-1-1, Hinodai**
**Hino-shi Tokyo(JP)**
Inventor: **Hiyama, Naoki**
**2-37-9, Kamimeguro Meguro-ku**
**Tokyo(JP)**

(74) Representative: **Barnard, Eric Edward et al**
**BROOKES & MARTIN High Holborn House**
**52/54 High Holborn**
**London WC1V 6SE(GB)**

## Description

Field of the Invention

This invention relates to an electrical connector, and in particular a connector for an FPC (flexible printed circuit).

Background to the Invention

Various FPC connectors, such as a ZIF (zero insertion force) connector and a connector using a soldering method are known in which an exposed-conductor portion of the forward end portion of an FPC is electrically connected to an array of contacts disposed within an insulating housing. In the solder type connector, the conductors exposed at the forward end portion of the FPC are connected by soldering to the contacts in a one-to-one correspondence. In the ZIF connector, the exposed-conductor portion of the forward end portion of the FPC is inserted into the female contacts arranged within a housing, and then the FPC is connected by a suitable external force to the female contacts. In the solder type connector, however, the exposed-conductors of the FPC must be individually connected to the contacts, which is time consuming. Furthermore, the FPC, once soldered, cannot be easily detached from the contact array. In the ZIF connector, the FPC can freely be attached to and detached from the female contact array, but two distinct steps are necessary: once when the FPC is inserted into the female contact array and once when an external force is applied to that assembly and vice versa for detachment. Furthermore, in the ZIF connector the external force is not uniformly distributed over the contacts and the interconnection can become defective.

From document US-A-3 696 319 is known a connector for flexible printed circuits, said connector comprising...

...an insulating housing having an elongated opening and an array of female resilient contacts arranged within the housing and accessible through the opening, each contact having a first region fitted to a first wall of said housing at one side of the elongated opening and a second contact region disposed alongside a second wall of the housing facing the first wall; and a flexible printed circuit assembly.

Summary of the Invention

An object of this invention is to provide an improved FPC connector.

According to the invention there is provided a connector for flexible printed circuits, said connector having a flexible printed circuit assembly further comprising a V-shaped spring member made from sheet material bent along a line to provide first and second inclined sections and a flexible printed circuit attached to the outside surface of the spring member having an area of exposed-conductors for electrical connection with the contact regions of the contacts, whereby the flexible printed circuit assembly can be inserted into the housing through the opening with the spring member engaged between the fixed and contact regions of the female contacts under resilient force. The resiliency of the contacts and of the spring member of the FPC assembly complement one another.

A connector constructed in accordance with the invention can ensure a positive electrical connection between an FPC and a female contact array and the FPC can be easily fitted to and dismantled from the female contact array. Moreover, the FPC need not be exposed to undue wear.

During assembly, the FPC assembly is gently compressed to bring the sections of the spring member closer together for insertion into the housing and the contacts. Preferably, guide means serve to guide the assembly as it is inserted into the housing. Once fitted, the sections of the spring member bias the exposed conductors into good electrical contact with the resilient contact sections of the contacts. Preferably a latch means serves to lock the FPC assembly in the housing but by grasping the assembly and compressing the sections of the spring member together the latch can be released permitting easy withdrawal of the assembly.

The FPC itself is preferably composed of a pair of insulating sheets between which the conductors are sandwiched other than in the area where the conductors, spaced apart to match the contacts, are exposed. One of these sheets is bonded to the V-shaped member to extend over both sections of the latter.

Conveniently, ribs on the inner surface of one of the walls of the housing locate the fixed regions of the contacts therebetween and a slot in a rear wall of the housing presents a row of pins connected to the individual contacts.

The invention may be understood more readily, and various other features of the invention may become apparent, from consideration of the following description.

Brief Description of the Drawings

Embodiments of the invention will now be described by way of examples only with reference to the accompanying drawings wherein:

Figure 1A is a perspective view of an FPC connector constructed in accordance with the invention with the housing partly broken away,

Figure 1B is an enlarged cross-sectional view of a portion of the FPC assembly of the connector, the view being taken along the line B-B in Figure 1A;

Figure 1C is an enlarged, cross-sectional view of another portion fo the FPC assembly of the connector, the view being taken along the line C-C in Figure 1A;

Figures 2 and 3A are sectional side views of the FPC connector showing the FPC assembly being inserted into the housing thereof;

Figure 3B is an enlarged view showing contacting parts of the connector;

Figure 3C is an enlarged cross-ectional view of a portion of the connector, the view being taken along the line X-X in Figure 3A;

Figure 4 is a sectional side view of a modified FPC connector constructed in accordance with the invention;

Figure 5 is a sectional side view of a further embodiment of an FPC connector constructed in accordance with the invention;

Figure 6 is a perspective view of the housing of the connector depicted in Figure 1A; and

Figures 7A and 7B are plan and side views, respectively, of a female contact used in the connector of Figure 1A.

Detailed Description of the Preferred Embodiments

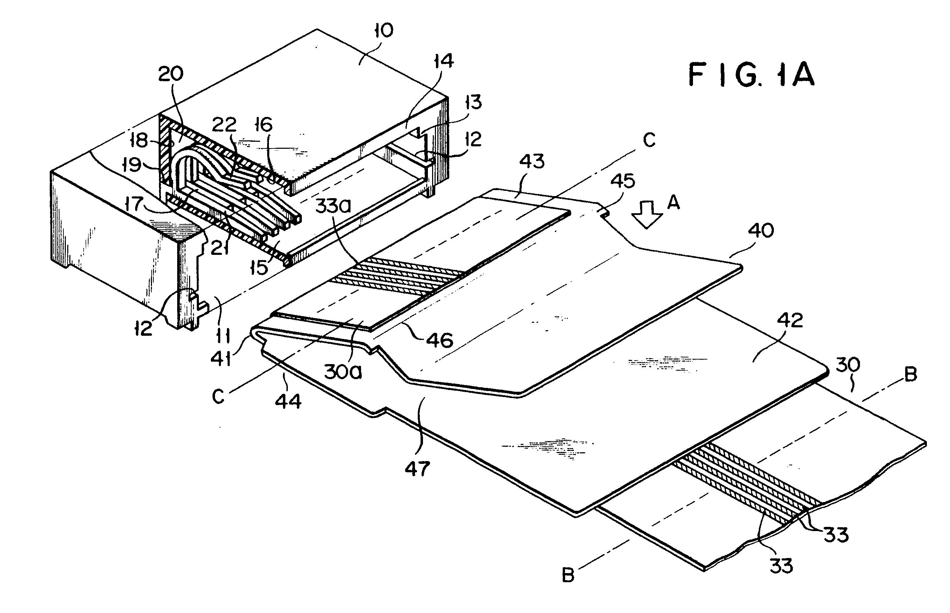

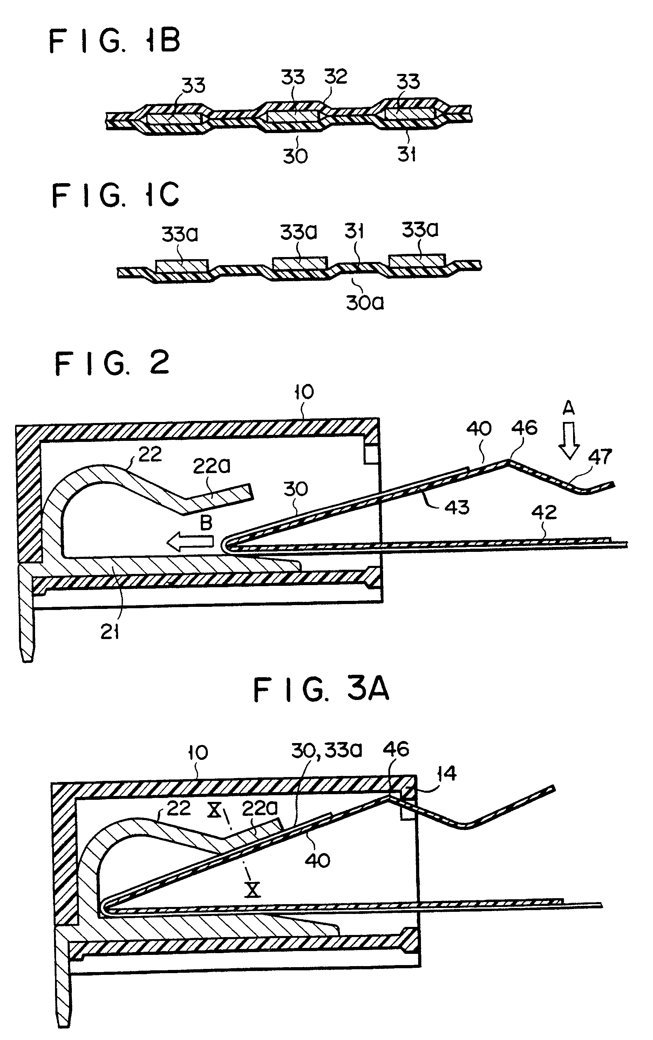

Referring to Figures 1, 2, 3, 6 and 7, a connector constructed in accordance with the invention is composed of complementary mating components in the form of a housing 10 providing a socket for receiving an FPC assembly 30. The housing is made from an insulating material and has an elongated opening 11 for access to female contacts 20 which are disposed within the housing 10 as shown in Figure 1A. Each of the contacts 20 has a fixed region 21 extending at right angles to the opening 11 which locates with a first (bottom) wall 15 of the housing 10 and a contact region 22 connected via an inner base region to the fixed region 21. The contact regions 22 of the contacts 20 lie alongside a second (top) wall 16 of the housing 10 opposite the first wall 15. The FPC assembly 30 is inserted through the opening 11 to connect with the female contacts 20 as described in more detail hereinafter, the FPC assembly 30 being composed of a flexible printed circuit and a V-shaped spring member 40. As shown in Figure 1B, the flexible printed circuit (FPC) consists of a first insulating sheet 31, a second insulating sheet 32 and a parallel array of flat conductors 33 between the insulating sheets 31 and 32. The spacing between each adjacent pair of conductors 33 is equal to the spacing between each adjacent pair of contacts 20. The conductors 33 are exposed at a forward end portion 30a as shown in Figures 1A and 1C so that their exposed portion 33a can electrically connect with the contact regions 22 of the female contacts 20. An end portion of the FPC including the forward end portion 30a is bonded to the outer surface of a V-shaped spring member 40. The spring member 40 is made from a sheet of resilient material e.g. synethic resin. The resin sheet is bent along a first line 41 to provide first and second inclined sections 42 and 43 one above the other forming the limbs of the V-profile. The sheets 31 and 32, and conductors 33 are likewise bent along the line 41 to present the exposed conductors 33a on the top section 43. The top section 43 is bent down again along a line 46 spaced from the conductors 33a to provide a further section 47 which is itself bent up again along a margin at its rear edge. The spring member 40 has lateral projections 44, 45 on the sections 42,43. The projections 44 act as guides while the projections 45 act as latches.

If no compressive force is applied to the spring member 40 in the direction of arrow A in Figure 1A, the sections 42,43 are spaced apart more widely than the space between the fixed regions 21 and the contact regions 22 of the contacts 20. Thus, when the FPC assembly 30 is inserted into the female contact array it can be held between the fixed and contact regions 21,22 of the female contacts 20 by the combined resilient forces.

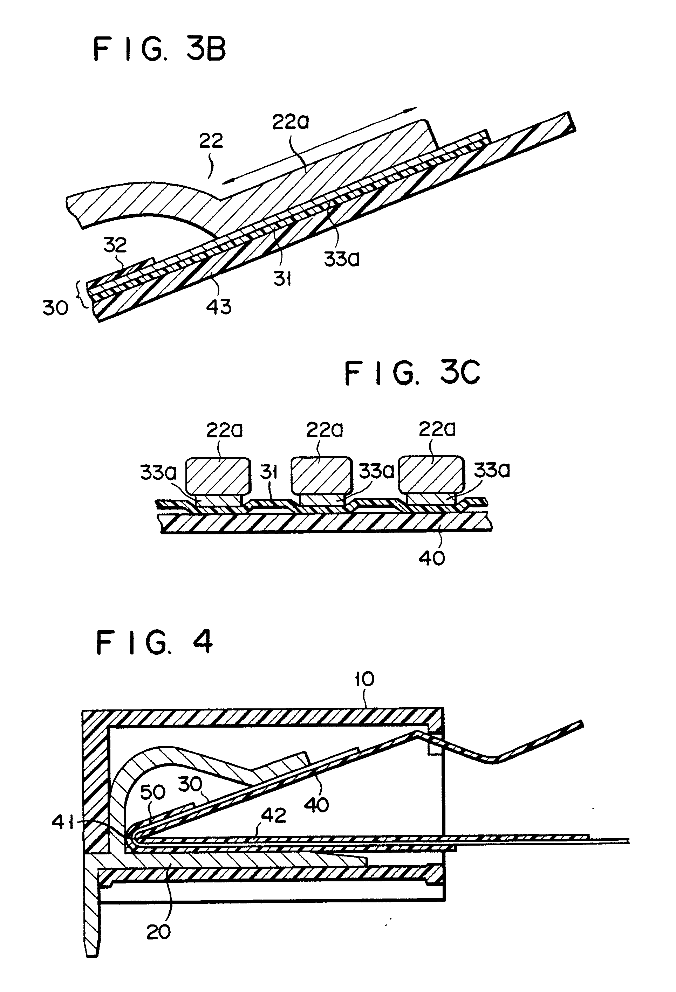

Figures 2 and 3A show the insertion of the FPC assembly into the female contact array in the housing 10. As shown in Figure 2, the top section 47 of the spring member 40 is pushed by, for example, the operator's fingers towards the bottom section 43 in the direction of the arrow A. The FPC assembly 30 is now inserted into the space between the fixed regions 21 and the contact regions 22 of the female contacts 20 in the direction of arrow B, with no frictional resistance produced there between. Grooves 12 in inner faces of the side walls of the housing 10 receive the guide projections 44 and guide the assembly 30 in place. When the compressive force is removed, the spring member 40 expands to urge the exposed conductors 33a against the inner surface of the contact regions 22 of the contacts 20. The contacts 20 also firmly hold the spring member 40 and hence the FPC assembly 30 in place. The electrical contact established between the conductors 33 and the contacts 20 is particularly reliable because of the dual resilience of the contacts 20 and the FPC assembly 30.

As shown in Figures 3B and 3C, the contact region 22 of each female contact 20 has a contact area 22a upwardly inclined at angle nearly equal to that of the section 43 of the spring member 40, ensuring a positive, reliable and firm electrical connection between the contact regions 22 and the associated exposed conductors 33a. As is also seen in Figure 3B, the conductors 33 are covered with the insulating sheet 32 at all other areas except for the exposed conductors 33a which make contact with the areas 22a. Stops 13 are formed at the front corners of the top wall 16 adjacent the side walls of the housing 10 and the projections 45 latch behind these stops 13 when the FPC assembly 30 is inserted as shown in Figure 3A. The top wall 16 also has a lip 14 which engages on the section 47 of the spring member 40.

Although the FPC assembly 30 is reliably held, the FPC assembly 30 can be readily detached from the array of female contacts 20 when it is pulled from the opening 11 of housing 10, with the first and second sections 42 and 43 of the spring member 40 compressed together by the operator's fingers.

The position and size of the projections or stops 13 is preferably selected so that undue expansion of the female contacts 20 by the spring member 40 is restricted.

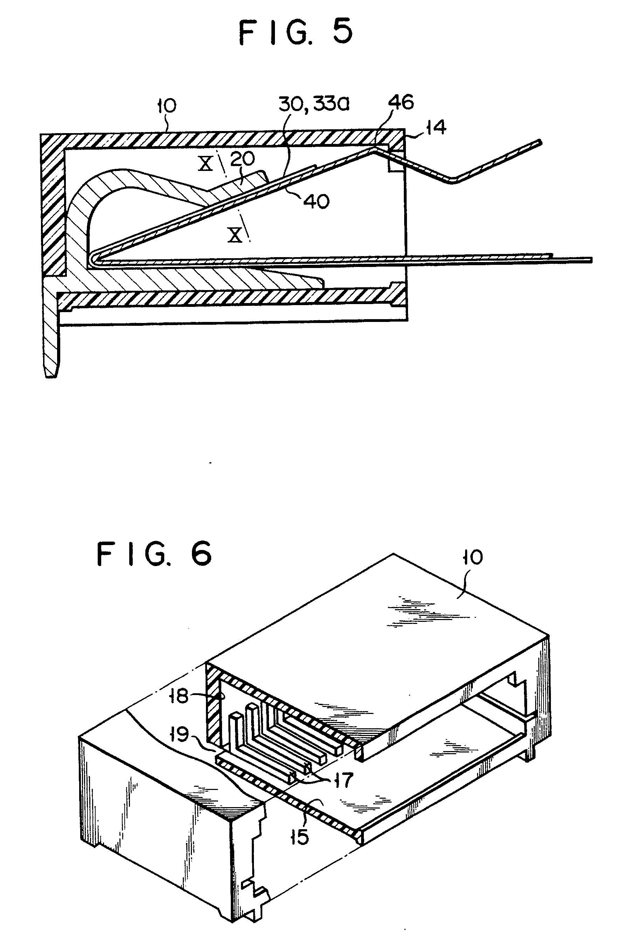

Figure 6 shows the housing 10 without the contacts 20. The housing 10 has ribs 17 arranged at the upper surface of the bottom wall 15. The ribs 17 are spaced apart and serve as spacers by which the female contacts are isolated from each other with the ribs 17 therebetween. The ribs 17 preferably also extend along a rear wall 18 perpendicular to the wall 15 in order to prevent the contact regions 22 from twisting. This rear wall 18 has a slot 19 near the bottom wall 15.

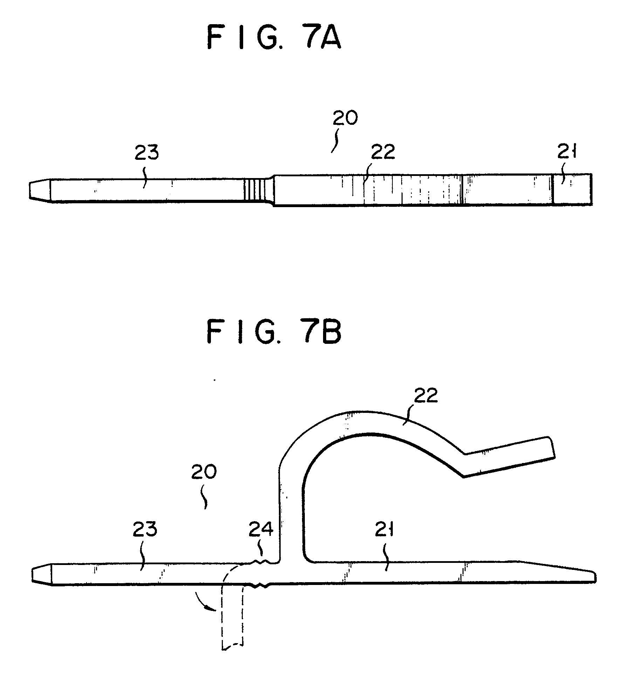

Figures 7A and 7B show one of the female contacts 20 to be attached to the housing 10. The contact 20 has the fixed region 21, the contact region 22 the base region connecting the regions 21,23 and a connecting pin 23 initially formed to project opposite to the region 21. Notches 24 are formed on the pin 23 near the regions 22. The pin 23 is bent perpendicular to the region 21, as indicated by the broken line (Figure 7B) after it has been inserted into the housing 10 to project through a slot 19 in the housing 10 (see Figure 6). The downward projecting ends of the pins 23 can be connected to a printed circuit board. The notches 24 make frictional contact with the slot to prevent displacement or stoppage of the contact 20.

In order to reduce the wear on the FPC assembly 30 due to friction during attachment and detachment with the female contacts 20 and particularly to protect the forward portion of the FPC assembly 30, an additional protective sheet 50 can be bonded to the forward portion to overlie the section 42 and part of the section 43 and extend around the bend 41 as shown in Figure 4. The sheet 50 may further facilitate the insertion of the FPC assembly 30 into the contacts 20.

Figure 5 shows a connector similar to the one shown in Figures 1, 2 and 3 except for the material of the spring member 40. In this modified connector, the spring member 40 is made from a metallic sheet e.g. stainless steel.

**Claims**

1. A connector for flexible printed circuits, said connector comprising:

    an insulating housing (10) having an elongated opening (11) and an array of female resilient contacts (20), arranged within the housing and accessible through the opening (11), each contact (20) having a first region (21) fitted to a first wall (15) of said housing at one side of the elongated opening and a second contact region (22) disposed alongside a second wall (16) of the housing facing the first wall; and a flexible printed circuit assembly, characterized in that said flexible printed circuit assembly comprises a V-shaped spring member (40) made from sheet material bent along a line to provide first and second sections (42,43) and a flexible printed circuit (31,32,33) attached to the outside surface of the spring member (40) having an area of exposed-conductors (33a) for electrical connection with the contact regions of the contacts, and in that the flexible printed circuit assembly is inserted into the housing through the opening with the spring member engaged between the fixed and contact regions of the female contacts under resilient force.

2. A connector according to claim 1, wherein the flexible printed circuit comprises an insulating sheet (31) bonded to the outer surface of the spring member (40) and a parallel array of flat conductors (33) disposed on the outer surface of the sheet (31), the conductors being spaced apart to correspond with the spacing between the contacts (20).

3. A connector according to claim 2, wherein the flexible printed circuit further comprises a further insulating sheet (32) which covers the conductor (33) over an area other than that where the conductors are exposed (33a), the further insulating sheet (32) extending over the section (42) of the V-shaped member (40) which lies adjacent the first regions (21) of the contacts (20).

4. A connector according to any one of claims 1 to 3, and further comprising a plurality of spacers (17) arranged on the first wall (15) of the housing (10) for locating the first regions (21) of the contacts (20) and isolating the contacts from one another.

5. A connector according to claim 4, wherein the spacers take the form of ribs (17) extending along the first wall (15) of the housing (10) in the same direction as the first regions (21) of the contacts (20) and having upstanding projections extending along a further wall of the housing perpendicular to the first wall (15).

6. A connector according to any one of claims 1 to 5, wherein the section (43) of the V-shaped member (40) which is intended to lie adjacent the contact regions (27) of the contacts (20) is bent further along a line toward the other section (42) which is intended to lie adjacent the first regions (21) of the contacts (20) to provide an extension section (47) which is bent again along another line at an end margin away from the other section (42).

7. A connector according to any one of claims 1 to 6, and further comprising projections (13) provided at the marginal edges of the second wall (14) of the housing adjacent the opening (11) which engage with stops (45) on the section (47) of the V-shaped member (40) which is intended to be adjacent to the contact regions (22) of the contacts (20) to locate the flexible printed circuit assembly (30) within the housing (10).

8. A connector according to any one of claims 1 to 6, wherein the section (43) of the V-shaped member (40) which is intended to be adjacent the contact regions (22) of the contacts (20) is provided with lateral projections (45) which act as a latch to engage with stops (13) formed adjacent the opening (11) of the housing (10) to retain the flexible printed circuit assembly (30) in the housing.

9. A connector according to any of claims 1 to 8 and further comprising guide means (44) formed at the side edges of the section (42) of the spring member (40) which is intended to lie adjacent the first regions (21) of the contacts (20), said guide means being engageable with rail means (12) on opposite side walls of the housing at the sides of the opening (11) to guide the flexible printed circuit assembly into the housing.

10. A connector according to claim 9, wherein the guide means (44) is composed of lateral projections of the section (42) of the spring member (40), and the rail means is composed of grooves (12) formed in the inner surfaces of the opposite side walls of the housing.

11. A connector according to any one of claims 1 to 10 and further comprising a protective sheet (50) mounted on the outer surface of said flexible printed circuit to extend at least partly over the sections of the V-shaped member.

12. A connector according to any one of claims 1 to 11 wherein the spring member (40) is made from a synthetic resin sheet or a metallic sheet.

13. A connector according to any one of claims 1 to 12, wherein the housing has a further opening (19) through which pins (23) connected to the contacts (20) extend.

**Revendications**

1. Un connecteur pour circuits imprimés flexibles, ledit connecteur comportant :
   un boîtier isolant (10) présentant une ouverture oblongue (11) et une rangée de contacts femelles élastiques (20), agencés à l'intérieur du boitier et accessibles par l'ouverture (11), chaque contact (20) présentant une première zone (21) fixée à une première paroi (15) dudit boîtier sur un côté de l'ouverture oblongue et une seconde zone de contact (22) disposée le long d'une seconde paroi (16) du boîtier, faisant face à la première paroi ; et un système de circuit imprimé flexible, caractérisé en ce que ledit système de circuit imprimé flexible comprend un organe élastique en forme de V (40) fait d'un matériau en feuilles coudé autour d'un axe afin de former des premier et second éléments (42, 43) et un circuit imprimé flexible (31, 32, 33) fixé à la face externe de l'organe élastique (40) présentant une zone de conducteurs dénudés (33a) pour réaliser une connexion électrique avec des zones de contact des contacts, et en ce que le système de circuit imprimé flexible est inséré dans le boîtier à travers l'ouverture, l'organe élastique étant engagé entre les zones fixes et de contact des contacts femelles sous l'action de la force élastique.

2. Un connecteur selon la revendication 1, dans lequel le circuit imprimé flexible comporte une feuille isolante (31) liée à la face externe de l'organe élastique (40) et une rangée parallèle de conducteurs plats (33) disposés sur la face externe de la feuille (31), les conducteurs étant espacés les uns des autres en correspondance à la distance entre les contacts (20).

3. Un connecteur selon la revendication 2, dans lequel le circuit imprimé flexible comporte en outre une autre feuille isolante (32) qui recouvre le conducteur (33) sur une zone autre que celle où les conducteurs sont dénudés (33a), la feuille isolante supplémentaire (32) s'étendant au dessus de l'élément (42) de l'organe en forme de V (40) qui se trouve au voisinage des premières zones (21) des contacts (20).

4. Un connecteur selon l'une quelconque des revendications 1 à 3, comportant en outre une pluralité d'entretoises (17) disposées sur la première paroi (15) du boîtier (10) afin de délimiter les premières zones (21) des contacts (20) et d'isoler les contacts les uns des autres.

5. Un connecteur selon la revendication 4, dans lequel les entretoises ont la forme de nervures (17) s'étendant le long de la première paroi (15) du boîtier (10) dans la même direction que les premières zones (21) des contacts (20) et présentant des protubérances en relief s'étendant le long d'une autre paroi du boîtier, perpendiculaire à la première paroi (15).

6. Un connecteur selon l'une quelconque des revendications 1 à 5, dans lequel l'élément (43) de l'organe en forme de V (40) qui est destiné à être au voisinage des zones de contact (27) des contacts (20) est coudé en outre autour d'un axe vers l'autre élément (42) qui est destiné à être au voisinage des premières régions (21) des contacts (20) afin de former un élément de prolongement (47) qui est coudé autour d'un autre axe au niveau d'une zone terminale en s'écartant de l'autre élément (42).

7. Un connecteur selon l'une quelconque des revendications 1 à 6, comportant en outre des protubérances (13) formées sur les bords marginaux de la seconde paroi (14) du boîtier, adjacentes à l'ouverture (11), qui viennent en contact avec des butées (45) formées sur la zone (47) de l'organe en forme de V (40) qui est destinée à être adjacente aux zones de contact (22) des contacts (20) afin de retenir le système de circuit imprimé flexible (30) à l'intérieur du boîtier (10).

8. Un connecteur selon l'une quelconque des revendications 1 à 6, dans lequel la zone (43) de l'organe en forme de V (40) qui est destinée à être adjacente aux zones de contact (22) des contacts (20) est pourvue de protubérances latérales (45) qui font fonction de verrou en venant en contact avec des butées (13) ménagées au voisinage de l'ouverture (11) du boîtier (10) afin de retenir le système de circuit imprimé flexible (30) dans le boîtier

9. Un connecteur selon l'une quelconque des revendications 1 à 8, comportant en outre des moyens de guidage (44) ménagés sur les bords latéraux de l'organe élastique (40) qui sont destinés à être adjacents aux premières zones (21) des contacts (20), lesdits moyens de guidage étant susceptibles d'entrer en contact avec des moyens de glissière (12) prévus sur les parois latérales opposées du boîtier au niveau des côtés de l'ouverture (11) afin de guider le système de circuit imprimé flexible dans le boîtier.

10. Un connecteur selon la revendication 9, dans lequel les moyens de guidage (44) sont constitués de protubérances latérales de la partie ou zone (42) de l'organe élastique (40), cependant que les moyens de glissière sont constitués de gorges (12) ménagées dans les faces internes des parois latérales opposées du boîtier.

11. Un connecteur selon l'une quelconque des revendications 1 à 10, comportant en outre une feuille protectrice (50) montée sur la surface externe dudit circuit imprimé flexible afin de s'étendre au moins partiellement au-dessus des zones de l'organe en forme de V.

12. Un connecteur selon l'une quelconque des revendications 1 à 11, dans lequel l'organe élastique (40) est formé d'une feuille de résine synthétique ou d'une feuille métallique.

13. Un connecteur selon l'une quelconque des revendications 1 à 12, dans lequel le boîtier présente une ouverture supplémentaire (19) à travers laquelle s'étendent des fiches (23) reliées aux contacts (20).

**Patentansprüche**

1. Verbinder für flexible gedruckte Schaltungen, wobei der Verbinder aufweist:

    ein Isoliergehäuse (10), welches eine längliche Öffnung (11) und eine Reihe von aufnehmenden, federnden Kontakten (20) hat, die in dem Gehäuse angeordnet und über die Öffnung (11) zugänglich sind, wobei jeder Kontakt (20) einen ersten Bereich (21), welcher passend zu einer ersten Wand (15) des Gehäuses an einer Seite der länglichen Öffnung ausgelegt ist, und einen zweiten Kontaktbereich (22) hat, der längs einer zweiten Wand (16) des Gehäuses angeordnet ist, welche zu der ersten Wand weist, und eine flexible gedruckte Schaltungsanordnung, dadurch **gekennzeichnet,** daß die flexible gedruckte Schaltungsanordnung ein V-förmiges Federteil (40) aufweist, das aus einem dünnen Material hergestellt ist, welches längs einer Linie gebogen ist, um erste und zweite Abschnitte (42, 43) zu bilden, und eine flexible gedruckte Schaltung (31, 32, 33), die an der außenseitigen Fläche des Federteils (40) angebracht ist, und einen Bereich mit freigelegten Leitern (33a) für eine elektrische Verbindung mit den Kontaktbereichen der Kontakte hat, und daß die flexible gedruckte Schaltungsanordnung in das Gehäuse über die Öffnung eingeführt wird, wobei das Federteil in Eingriff zwischen den festen Bereichen und den Kontaktbereichen der aufnehmenden Kontakte unter Federkraft kommt.

2. Verbinder nach Anspruch 1, dadurch gekennzeichnet, daß die flexible gedruckte Schaltung eine Isolierfolie (31) aufweist, die mit der äußeren Fläche des Federteils (40) verbunden ist, und eine parallele Gruppe von Flachleitern (33) aufweist, die auf der äußeren Fläche der Folie (31) angeordnet sind, wobei die Leiter einen Abstand haben, welcher dem Abstand zwischen den Kontakten (20) entspricht.

3. Verbinder nach Anspruch 2, bei dem die flexible gedruckte Schaltung ferner eine weitere Isolierfolie (32) aufweist, welche den Leiter (33) über einem Bereich, abgesehen von jenem bedeckt, an dem die Leiter freiliegen (33a), wobei die weitere Isolierfolie (32) sich über den Abschnitt (42) des V-förmigen Teils (40) erstreckt, der in der Nähe der ersten Bereiche (21) der Kontakte (20) liegt.

4. Verbinder nach einem der Ansprüche 1 bis 3, welcher ferner eine Mehrzahl von Distanzstücken (17) aufweist, die auf der ersten Wand (15) des Gehäuses (10) zur Anordnung der ersten Bereiche (21) der Kontakte (20) und zum Isolieren der Kontakte voneinander angeordnet sind.

5. Verbinder nach Anspruch 4, bei dem die Distanzstücke in Form von Rippen (17) ausgelegt sind, die längs der ersten Wand (15) des Gehäuses (10) in dieselbe Richtung wie die ersten Bereiche (21) der Kontakte (20) verlaufen und hochstehende Vorsprünge haben, die längs einer weiteren Wand des Gehäuses senkrecht zu der ersten Wand (15) verlaufen.

6. Verbinder nach einem der Ansprüche 1 bis 5, bei dem der Abschnitt (43) des V-förmigen Teils (40), das in der Nähe der Kontaktbereiche (27) der Kontakte (20) zu liegen kommen soll, weiter längs einer Linie in Richtung zu dem anderen Abschnitt (42) gebogen ist, der in der Nähe der ersten Bereiche (21) der Kontakte (20) zu liegen kommen soll, um einen Verlängerungsabschnitt (47) zu bilden, der wiederum längs der anderen Linie an einem Endrand von dem anderen Abschnitt (42) wegweisend gebogen ist.

7. Verbinder nach einem der Ansprüche 1 bis 6, welcher ferner Vorsprünge (13) aufweist, die an den Randkanten der zweiten Wand (14) des Gehäuses in der Nähe der Öffnung (11) vorgesehen sind, und die mit Anschlägen (45) auf dem Abschnitt (47) des V-förmigen Teils (40) zusammenarbeiten, welches in der Nähe der Kontaktbereiche (22) der Kontakte (20) zu liegen kommen soll, um die flexible gedruckte Schaltungsanordnung (30) in dem Gehäuse (10) anzuordnen.

8. Verbinder nach einem der Ansprüche 1 bis 6, bei dem der Abschnitt (43) des V-förmigen Teils (40), der in der Nähe der Kontaktbereiche (42) der Kontakte (20) zu liegen kommen soll, mit Quervorsprüngen (45) versehen ist, die als eine Verriegelung im Zusammenwirken mit den Anschlägen (13) wirken, die in der Nähe der Öffnung (11) des Gehäuses (10) ausgebildet sind, um die flexible gedruckte Schaltungsanordnung (30) im Gehäuse festzuhalten.

9. Verbinder nach einem der Ansprüche 1 bis 8, welcher ferner eine Führungseinrichtung (44) aufweist, die an den Seitenrändern des Abschnitts (42) des Federteils (40) ausgebildet ist, welcher in der Nähe der ersten Bereiche (21) der Kontakte (20) zu liegen kommen soll, wobei die Führungseinrichtung in Eingriff mit Schieneneinrichtungen (12) auf den gegenüberliegenden Seitenwänden des Gehäuses an den Seiten der Öffnung (11) bringbar ist, um die flexible gedruckte Schaltungsanordnung in dem Gehäuse zu führen.

10. Verbinder nach Anspruch 9, bei dem die Führungseinrichtung (44) die Quervorsprünge des Abschnitts (42) des Federteils (40) umfaßt, und die Schieneneinrichtungen Ausnehmungen (12) umfassen, die in den inneren Flächen der gegenüberliegenden Seitenwände des Gehäuses ausgebildet sind.

11. Verbinder nach einem der Ansprüche 1 bis 10, welcher ferner eine Schutzfolie (50) aufweist, die auf der äußeren Fläche der flexiblen gedruckten Schaltung angebracht ist, und sich wenigstens teilweise über die Abschnitte des V-förmigen Teils erstreckt.

12. Verbinder nach einem der Ansprüche 1 bis 11, bei dem das Federteil (40) aus einer Kunstharzfolie oder einer Metallfolie hergestellt ist.

13. Verbinder nach einem der Ansprüche 1 bis 12, bei dem das Gehäuse eine weitere Öffnung (19) hat, durch welche Stifte (23) verlaufen, die mit den Kontakten (20) verbunden sind.

F I G. 1A

EP 0 214 830 B1

# F I G. 1B

# F I G. 1C

# F I G. 2

# F I G. 3A

F I G. 3B

F I G. 3C

F I G. 4

# FIG. 5

# FIG. 6

# F I G. 7A

# F I G. 7B